**Europäisches Patentamt**

**European Patent Office**

**Office européen des brevets**

(19)

(11) Veröffentlichungsnummer : **0 031 947**
**B1**

(12) # EUROPÄISCHE PATENTSCHRIFT

(45) Veröffentlichungstag der Patentschrift :
**13.03.85**

(21) Anmeldenummer : **80108166.2**

(22) Anmeldetag : **23.12.80**

(51) Int. Cl.⁴ : **H 03 K 19/082, H 01 L 27/06,
H 01 L 29/04**

(54) Monolithisch integrierbare Logikzelle.

(30) Priorität : **08.01.80 DE 3000491**

(43) Veröffentlichungstag der Anmeldung :
**15.07.81 Patentblatt 81/28**

(45) Bekanntmachung des Hinweises auf die Patenterteilung : **13.03.85 Patentblatt 85/11**

(84) Benannte Vertragsstaaten :
**FR GB IT**

(56) Entgegenhaltungen :
**DE-A- 2 824 275
GB-A- 2 011 167
US-A- 4 165 470
Lloyd P. Hunter: "Handbook of Semiconductor Electronics" 3rd edition 1970 Mc Graw-Hill Book
Company, p. 18-3 - 18-7**

(73) Patentinhaber : **Siemens Aktiengesellschaft
Berlin und München Wittelsbacherplatz 2
D-8000 München 2 (DE)**

(72) Erfinder : **Kranzer, Ditmar, Dr. techn.
Theodor-Heuss-Strasse 8
D-8011 Putzbrunn (DE)**
Erfinder : **Rydval, Peter, Dipl.-Ing.
Hirtentäschelweg 11
D-8000 München 70 (DE)**
Erfinder : **Werner, Wolfgang, Dr. Ing.
Lorenzonistrasse 66
D-8000 München 90 (DE)**

**Beschreibung**

Die Erfindung betrifft monolithisch integrierbare Logikzelle, bei der jeder der vorgesehenen Signaleingänge durch den Basisanschluß je eines Bipolartransistors gegeben ist, dessen Emitter an dem Versorgungsanschluß für das Bezugspotential und dessen Kollektor am Signalausgang der Logikzelle liegt, bei der im Falle mehrerer Signaleingänge die dann einander parallel geschalteten Transistoren einander gleich sind, und bei der schließlich die Verbindung des Signalausgangs zu dem das Versorgungspotential liefernden Versorgungsanschluß eine Schottkydiode enthält, deren Kathode an den Kollektor der vorgesehenen Transistoren gelegt ist.

Eine derartige Logikzelle ist in der DE-A-28 24 275 beziehungsweise in der US-A-4 165 470 beschrieben. Dabei ist in der DE-A-28 24 275 angegeben, daß für den die einzige Verbindung vom Signalausgang und damit von den Kollektoren der Transistoren der Logikzelle zu dem Versorgungsanschluß für das Versorgungspotential bildenden Lastwiderstand eine nichtlineare Strom-Spannungscharakteristik erwünscht ist, deren Steigung größer als die des Emitter-Basis-Übergangs der Transistoren der Logikzelle ist, weil dadurch eine Steuerung in einem weiten Geschwindigkeitsbereich, ein gutes Power-Delay Product und eine niederohmige Ausgangsstufe gewährleistet ist.

Die in der DE-A-28 24 275 beschriebene Logikzelle sieht deshalb die Verwendung zweier in Serie liegender Dioden für die Verkörperung des Lastwiderstands vor, weil die Verwendung von nur einer Diode und auch einer normalen Schottkydiode als Lastwiderstand nicht ausreichend ist, um das gewünschte Ziel zu erreichen. Andererseits braucht man bei der Realisierung des Lastwiderstands durch zwei in Serie liegende Dioden bedeutend mehr Platz pro Logikzelle in dem für die Aufnahme der Zelle vorgesehenen Halbleiterchip, als wenn der Lastwiderstand nur durch eine einzige Diode oder Schottkydiode realisiert wäre.

Andererseits ist bei den in der US-A-4 165 470 beschriebenen Logikzellen zwar nur eine einzige Schottkydiode pro Lastwiderstand vorgesehen. Diese liegt aber in Reihe mit einer Stromquelle, die ihrerseits den Platzbedarf für die einzelne Zelle vergrößert.

In der europäischen Patentanmeldung 80 107 831.2, veröffentlicht am 15.07.81 unter der Nummer 0 031 094, ist eine integrierbare Halbleiterspeicherzelle mit zwei einander gleichen Bipolartransistoren beschrieben, deren Kollektoren in Serie mit je einem eine nichtlineare Strom-Spannungscharakteristik aufweisenden Schaltungsteil an ein gemeinsames erstes elektrisches Versorgungspotential gelegt und außerdem jeweils mit der Basis des jeweils anderen dieser beiden Transistoren verbunden sind, bei der ferner je ein Emitter dieser beiden Transistoren an einen gemeinsamen Anschluß für ein zweites Versorgungspotential gelegt und je ein weiterer Emitter zur Signalsteuerung der Halbleiterspeicherzelle vorgesehen ist, bei der außerdem der zwischen dem Kollektor jedes der beiden Transistoren und dem das erste elektrische Versorgungspotential führenden Eingang liegende Schaltungsteil in allen Punkten seiner Strom-Spannungscharakteristik einen stärkeren Anstieg als die Strom-Spannungscharakteristik des Emitter-Basis-Übergangs der beiden Transistoren hat. Hierbei bestehen die beiden Schaltungsteile mit nichtlinearer Strom-Spannungscharakteristik jeweils nur aus einer Schottkydiode, deren Anode zusammen mit der Anode der den anderen nichtlinearen Schaltungsteil bildenden Schottkydiode an dem das erste Versorgungspotential liefernden gemeinsamen Anschluß und deren Kathode am Kollektor jeweils des einen und an der Basis des anderen Transistors liegt, und jede der beiden Schottkydioden ist auf einer aus polykristallinem Halbleitermaterial bestehenden Unterlage erzeugt.

Diese europäische Patentanmeldung fällt hinsichtlich des Standes der Technik unter Artikel 54(3) EPÜ.

Die Erfindung hat nun die Aufgabe, eine Möglichkeit anzugeben, bei der die Verbindung zwischen der Klemme für das Versorgungspotential zu dem Signalausgang der Logikzelle und damit zu den Kollektoren der zugehörigen Bipolartransistoren lediglich durch eine einzige Schottkydiode ohne weitere Schaltungsteile, wie Widerstände usw., gegeben ist.

Gemäß der Erfindung ist hierzu vorgesehen, daß die mit ihrer Kathode am Kollektor der Transistoren der Logikzelle liegende und die einzige Verbindung zwischen dem Kollektor und dem Versorgungsanschluß für das Versorgungspotential bildende Schottkydiode unmittelbar mit diesem Versorgungsanschluß verbunden ist, daß dabei der die Anode der Schottkydiode bildende Kontakt sich unmittelbar auf einer aus polykristallinem Halbleitermaterial, insbesondere aus polykristallinem Silicium, bestehenden Unterlage angeordnet und zusammen mit dieser Unterlage derart beschaffen ist, daß die Steigung der Strom-Spannungscharakteristik der Schottkydiode größer als die Steigung der Stromspannungscharakteristik des Emitter-Basis-Übergangs der Transistoren der Logikzelle ist.

Durch die Verwendung einer aus polykristallinem Halbleitermaterial, insbesondere aus polykristallinem Silicium und dem darauf aufgebrachten Schottkykontakt bestehenden Schottkydiode als Lastelement erhält man einen Lastwiderstand mit nichtlinearer Strom-Spannungscharakteristik, deren Steigung erfahrungsgemäß wesentlich größer als die einer aus denselben Materialien bestehenden Schottkydiode ist, bei der der Schottkykontakt jedoch auf einer monokristallinen Halbleiterunterlage aufgebracht ist. Diese Erkenntnis wird bei der vorliegenden Erfindung ausgenutzt und damit die Möglichkeit der Erzeugung einer Logikzelle mit den in der DE-OS angegebenen Vorteilen geschaffen, ohne daß dabei der Nachteil des beträchtlichen Platzbedarfs der dort bzw. auch in der US-A-4 165 470 beschriebenen Logikzellen in Kauf genommen werden muß.

In diesem Zusammenhang ist jedoch noch auf den Stand der Technik gemäß der GB-A 2 011 167 hinzuweisen, in der eine Logikzelle mit Schottkykontakten, die auf einer mit dem Kollektor eines Transistors in unmittelbarer Verbindung stehenden dotierten polykristallinen Siliciumschicht aufgebracht sind. Bei der dort beschriebenen Logikzelle handelt es sich jedoch um eine I²L-Struktur und nicht um eine Logikzelle der eingangs gegebenen Definition. Außerdem hat die polykristalline Struktur der Halbleiterunterlage der Schottkykontakte bei der bekannten Anordnung keinen Einfluß auf das betriebsmäßige Verhalten der bekannten Logikzelle. Schließlich sind auch in den Offenbarungen der GB-Schrift keine Ausführungen über das Verhalten der Strom-Spannungskennlinie einer auf einer polykristallinen Halbleiterunterlage erzeugten Schottkydiode enthalten.

Gemäß der Erfindung empfiehlt es sich ferner, daß der die Schottkydiode bildende Metallkontakt auf einer Schicht aus intrinsic-leitendem polykristallinen Halbleitermaterial, insbesondere Silicium, bestehenden Unterlage erzeugt wird. Man verwendet hier also zweckmäßiger Weise undotiertes polykristallines Silicium, wie man es leicht durch pyrolytische Zersetzung von hochgereinigtem Monosilan (SiH₄) an der Oberfläche des auf 4-500 °C erhitzten und den übrigen Teil der Schaltung aufnehmenden Siliciumeinkristalls oder noch einfacher durch Glimmentladungsabscheidung erhalten kann.

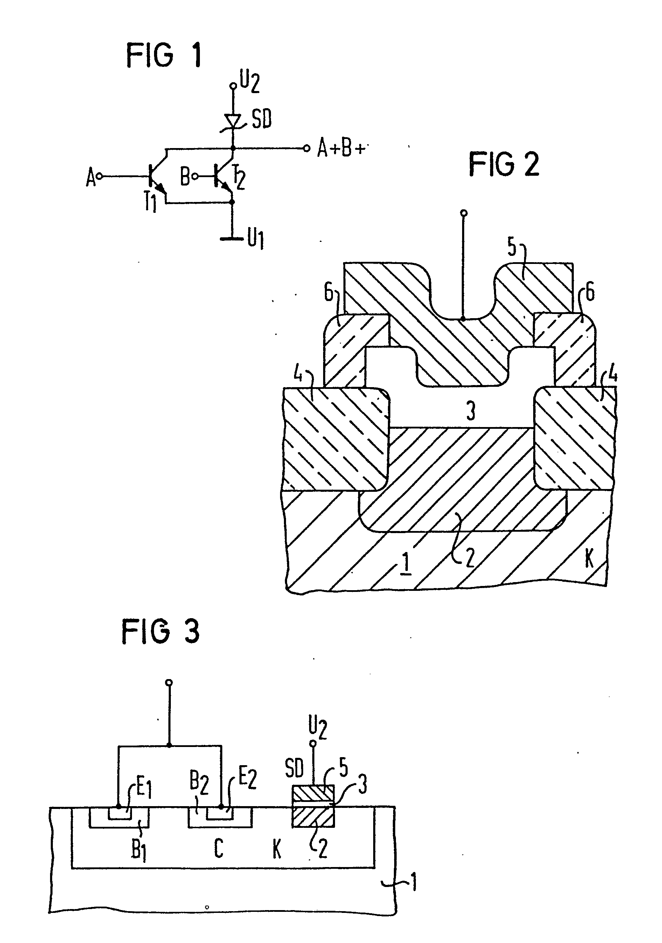

Die Erfindung wird nun anhand der Figuren 1 bis 3 näher beschrieben. Figur 1 stellt das Schaltbild der Logikzelle, Fig. 2 den bevorzugten Aufbau der Schottkydiode und Fig. 3 ein mögliches Layout bei der Realisierung der Zelle gemäß Fig. 1 dar.

Im Falle der Fig. 1 hat man ein NOR-Gatter mit zwei Eingängen A und B und demgemäß zwei Transistoren $T_1$ und $T_2$, die in der oben definierten Weise an die Kathode der Schottkydiode SD und damit über die Schottkydiode SD an das zweite Betriebspotential $U_2$ der Logikzelle gelegt sind. Die Emitter der Transistoren $T_1$, $T_2$ liegen im Beispielsfall unmittelbar am ersten Betriebspotential oder Bezugspotential $U_1$ der Zelle, so daß die Transistoren $T_1$ und $T_2$ mit ihren Emitter-Kollektorstrecken einander parallel geschaltet sind, so daß eine NOR-Funktion zustande kommt, die am Ausgang A + B abnehmbar ist.

Ersichtlich könnten auch mehr als zwei Transistoren bezüglich ihrer Emitter-Kollektorstrecken parallel geschaltet sein, so daß man ein NOR-Gatter mit entsprechend mehr logischen Eingängen hätte. Andererseits könnte die Schaltung auch nur einen einzigen Transistor aufweisen, so daß man einen einfachen Inverter hätte.

Die in Fig. 2 dargestellte Schottkydiode SD hat als Kathode einen aus monokristallinem $n^+$-dotiertem Silicium bestehenden Bereich 2 und als Anode einen vorteilhafterweise aus Platin bestehenden Metallkontakt 5. Zwischen dem Bereich 2 aus hochdotiertem einkristallinem Silicium und dem Kontakt 5 befindet sich eine aus hochreinem, also intrinsic-leitendem Silicium bestehende Schicht 3, die zweckmäßig auf eine Stärke im Bereich von etwa 4 000 AE bis etwa 5 000 AE eingestellt ist.

Da die Realisierung der Erfindung gewöhnlich in Form eines Teils einer monolithisch integrierten, insbesondere auf digitaler Grundlage arbeitenden Schaltung erfolgt, wird man im allgemeinen die hochdotierte Zone 2, also die Kathode der Schottkydiode SD, an der Oberfläche des die Schaltung aufnehmenden Siliciumeinkristalls 1 innerhalb der den Kollektor K der Transistoren $T_1$, $T_2$, ... bildenden n-dotierten einkristallinen Zone C vorsehen (Fig. 3).

Wesentlich ist für die Erfindung, daß bereits durch Verwendung einer einzigen Schottkydiode als Lastwiderstand die der DE-OS 28 24 275 angegebenen Vorteile erhalten werden, sobald die Schottkydiode nicht an der Oberfläche eines monokristallinen Halbleiterkörpers, sondern an der Oberfläche einer polykristallinen Unterlage aus Halbleitermaterial erzeugt ist. Dabei genügt es, ganz dünne Schichten von der Größenordnung einiger tausend AE zu verwenden, wenn die polykristalline Schicht aus undotiertem Halbleitermaterial, insbesondere Silicium, besteht. Grundsätzlich gilt in allen von der Erfindung vorgeschlagenen Möglichkeiten, daß die Bedingung

$$dU_L/dI_L > dU_{BE}/dI_E$$

erfüllt ist, wobei der erste Differentialquotient die Steilheit der Strom-Spannungskennlinie des Lastelements, also der Schottkydiode, und der zweite Differentialquotient die Steilheit der Strom-Spannungskennlinie der durch den Emitter-Basis-Übergang der Transistoren $T_1$, $T_2$, ... gegebenen Dioden ist.

**Ansprüche**

1. Monolithisch integrierbare Logikzelle, bei der jeder der vorgesehenen Signaleingänge (A, B, ...) durch den Basisanschluß je eines Bipolartransistors gegeben ist, dessen Emitter an dem Versorgungsanschluß für das Bezugspotential und dessen Kollektor am Signalausgang der Logikzelle liegt, bei der im Falle mehrerer Signaleingänge die dann parallel geschalteten Transistoren ($T_1$, $T_2$, ...) einander gleich sind, und bei der schließlich die Verbindung des Signalausgangs zu dem das Versorgungspotential liefernden Versorgungsanschluß eine Schottkydiode enthält, deren Kathode an den Kollektor der vorgesehenen Transistoren gelegt ist, dadurch gekennzeichnet, daß die mit ihrer Kathode am Kollektor der Transistoren ($T_1$, $T_2$, ...) liegende

und die einzige Verbindung zwischen dem Kollektor und dem Versorgungsanschluß für das Versorgungspotential (U₂) bildende Schottkydiode (SD) mit ihrer Anode unmittelbar mit diesem Versorgungsanschluß verbunden ist, daß dabei der die Anode der Schottkydiode bildende Kontakt sich unmittelbar auf einer aus polykristallinem Halbleitermaterial, insbesondere aus polykristallinem Silicium, bestehenden Unterlage (3) angeordnet und zusammen mit dieser Unterlage (3) derart beschaffen ist, daß die Steigung der Strom-Spannungscharakteristik der Schottkydiode (SD) größer als die Steigung der Strom-Spannungscharakteristik des Emitter-Basis-Übergangs der Transistoren der Logikzelle ist.

2. Logikzelle nach Anspruch 1, dadurch gekennzeichnet, daß der die Schottkydiode (SD) bildende Metallkontakt auf einer aus intrinsicleitendem, insbesondere aus undotiertem polykristallinen Halbleitermaterial bestehenden Unterlage aufgebracht ist.

3. Logikzelle nach Anspruch 2, dadurch gekennzeichnet, daß die Stärke der aus intrinsicleitendem polykristallinen Silicium bestehenden Unterlage für den Schottkykontakt der Schottkydiode (SD) im Bereich von etwa 4 000 bis 5 000 AE liegt.

4. Logikzelle nach den Ansprüchen 1 bis 3, dadurch gekennzeichnet, daß die polykristalline Halbleiterschicht (3) der Schottkydiode (SD) an der dem Schottkykontakt (Anode) gegenüberliegenden Seite mit einer Schicht (2) aus hochdotiertem, einkristallinem Halbleitermaterial, insbesondere Silicium, kontaktiert ist.

5. Logikzelle nach den Ansprüchen 1 bis 4, dadurch gekennzeichnet, daß die Transistoren (T₁, T₂, ...) der Logikzelle als einander gleiche npn-Transistoren ausgebildet sind.

6. Logikzelle nach Anspruch 5, dadurch gekennzeichnet, daß die Transistoren (T₁, T₂, ...) der Schaltung eine gemeinsame Kollektorzone (K) aufweisen, die in einem, insbesondere aus Silicium bestehenden Halbleitereinkristall ausgebildet ist, daß in dieser gemeinsamen Kollektorzone (K) pro Transistor (T₁, T₂, ...) eine Basiszone (B₁, B₂, ...) und in jeder dieser Basiszone (B₁, B₂, ...) mindestens je eine Emitterzone (E₁, E₂, ...) erzeugt ist, daß ferner die Oberfläche der Kollektorzone (K) einen hochdotierten einkristallinen Bereich (2) vom Leitungstyp der Kollektorzone (K) aufweist, auf der sich die polykristalline Halbleiterschicht (3) und der Schottkykontakt (5) der gemeinsamen Schottkydiode befindet.

7. Logikzelle nach den Ansprüchen 1 bis 6, dadurch gekennzeichnet, daß bei Verwendung von polykristallinem Silicium als Unterlage (3) für den Schottkykontakt (5) der Schottkydiode (SD) als Material für den Schottkykontakt Platin oder eine Legierung aus Nickel-Wolfram verwendet ist.

**Claims**

1. A monolithically integratable logic cell, in which each of the signal inputs (A, B, ...) provided is formed by the base terminal of a bipolar transistor, the emitter of which is connected to the supply terminal for the reference potential and the collector of which is connected to the signal output of the logic cell, wherein, in the case of a plurality of signal inputs, the transistors (T₁, T₂, ...), which are then connected in parallel, are identical, and wherein, finally, the connection of the signal output to the supply terminal, which supplies the supply potential, contains a Schottky diode, the cathode of which is connected to the collector of the transistors provided, characterised in that the Schottky diode (SD), which has its cathode connected to the collector of the transistors (T₁, T₂, ...) and forms the only connection between the collector and the supply terminal for the supply potential (U₂), has its anode directly connected to the supply terminal; that the contact, which forms the anode of the Schottky diode is directly arranged on a substrate (3) consisting of a polycrystalline semiconductor material, in particular polycrystalline silicon, and, together with this substrate (3) is so constituted that the slope of the current-voltage characteristic curve of the Schottky diode (SD) is greater than the slope of the current-voltage characteristic curve of the emitter-base junction of the transistors of the logic cell.

2. A logic cell according to Claim 1, characterised in that the metal contact which forms the Schottky diode (SD), is put on a substrate which consists of an intrinsic-conductive, in particular undoped, polycrystalline semiconductor material.

3. A logic cell according to Claim 2, characterised in that the thickness of the substrate for the Schottky contact of the Schottky diode (SD), which consists of intrinsic-conductive polycrystalline silicon, lies in the range of approximately 4 000 to 5 000 Å.

4. A logic cell according to Claims 1 to 3, characterised in that the polycrystalline semiconductor layer (3) of the Schottky diode (SD) is in contact with a layer (2) consisting of a highly-doped, monocrystalline semiconductor material, in particular silicon, on the side opposite the Schottky contact (anode).

5. A logic cell according to Claims 1 to 4, characterised in that the transistors (T₁, T₂, ...) of the logic cell are formed as identical npn-transistors.

6. A logic cell according to Claim 5, characterised in that the transistors (T₁, T₂, ...) of the circuit have a common collector zone (K) which is formed in a semiconductor monocrystal, in particular one made of silicon; that a base zone (B₁, B₂, ...) is produced for each transistor (T₁, T₂, ...) in this common collector zone (K) and at least one emitter zone (E₁, E₂, ...) is produced in each of these base zones (B₁, B₂, ...); that, moreover, the surface of the collector zone (K) has a highly doped monocrystalline region (2) of the conductivity type of the collector zone (K), on which the polycrystalline semiconductor layer (3) and the Schottky contact (5) of the common Schottky diode are arranged.

7. A logic cell according to Claims 1 to 6, characterised in that, when using polycrystalline silicon as a substrate (3) for the Schottky contact (5) of the Schottky diode (SD), platinum or an alloy consisting of nickel-tungsten is used as material for the Schottky contact.

**Revendications**

1. Cellule logique intégrable de façon monolithique, dans laquelle chacune des entrées prévues de signaux (A, B...) est formée par la borne de base d'un transistor bipolaire, dont l'émetteur est raccordé à la borne d'alimentation délivrant le potentiel de référence et dont le collecteur est raccordé à la sortie des signaux de la cellule logique, et dans laquelle dans le cas de plusieurs entrées de signaux, les transistors ($T_1$, $T_2$...) branchés alors en parallèle sont identiques entre eux et dans lequel enfin la liaison reliant la sortie des signaux à la borne d'alimentation délivrant le potentiel d'alimentation contient une diode Schottky dont la cathode est raccordée au collecteur des transistors prévus, caractérisée par le fait que la diode Schottky (SD), dont la cathode est raccordée au collecteur des transistors ($T_1$, $T_2$...) et qui forme la seule liaison entre le collecteur et la borne d'alimentation servant à délivrer le potentiel d'alimentation ($U_2$), est reliée par son anode directement à cette borne d'alimentation, que le contact constituant l'anode de la diode Schottky est disposé directement sur un support (3) constitué en un matériau semiconducteur polycristallin, notamment en silicium polycristallin, et est agencé, ainsi que ce support (3), de telle manière que la pente de la caractéristique courant-tension de la diode Schottky (SD) est supérieure à la pente de la caractéristique courant-tension de la jonction émetteur-base du transistor de la cellule logique.

2. Cellule logique suivant la revendication 1, caractérisée par le fait que le contact métallique constituant la diode Schottky (SD) est déposé sur un support constitué par un matériau semiconducteur à conduction intrinsèque, notamment par un matériau semiconducteur polycristallin non dopé.

3. Cellule logique suivant la revendication 2, caractérisée par le fait que l'épaisseur du support, est constituée par du silicium polycristallin à conduction intrinsèque, pour le contact Schottky de la diode Schottky (SD) se situe dans la plage comprise entre environ 4 000 et 5 000 AE.

4. Cellule logique suivant les revendications 1 à 3, caractérisée par le fait que la couche semiconductrice polycristalline (3) de la diode Schottky (SD) est contactée, sur la face située à l'opposé du contact Schottky (anode), par une couche (2) constituée par un matériau semiconducteur monocristallin fortement dopé, notamment du silicium.

5. Cellule logique suivant les revendications 1 à 4, caractérisée par le fait que les transistors ($T_1$, $T_2$...) de la cellule logique sont réalisés sous la forme de transistors npn identiques.

6. Cellule logique suivant la revendication 5, caractérisée par le fait que les transistors ($T_1$, $T_2$...) du circuit possèdent une zone commune de collecteur (K) qui est réalisée en un monocristal semiconducteur constitué notamment par du silicium, que pour chaque transistor ($T_1$, $T_2$...), qu'une zone de base ($B_1$, $B_2$...) est réalisée dans cette zone commune de collecteurs (K) et qu'au moins une zone d'émetteur ($E_1$, $E_2$...) est réalisée dans chacune de ces zones de base ($B_1$, $B_2$...), qu'en outre la face supérieure de la zone de collecteurs (K) possède une zone monocristalline fortement dopée (2), possédant le type de conductivité de la zone de collecteur (K) et sur laquelle sont situés la couche semiconductrice polycristalline (3) et le contact à Schottky (5) de la diode Schottky commune.

7. Cellule logique suivant les revendications 1 à 6, caractérisée par le fait que dans le cas de l'utilisation de silicium polycristallin en tant que support (3) pour le contact de Schottky (5) de la diode Schottky (SD), on utilise du platine ou un alliage de nickel-tungstène comme matériau pour le contact de Schottky.

FIG 1

U₂

SD

A+B+

A

B

T₁

T₂

U₁

FIG 2

5

6

6

4

4

3

1

2

K

FIG 3

U₂

SD

5

3

E₁

B₂

E₂

B₁

C

K

2

1